# EUROPEAN PATENT APPLICATION

(11) **EP 2 765 614 A1**
(43) Date of publication of application: **13.08.2014**
(21) Application number: 13154951.1
(22) Date of filing: 12.02.2013
(51) Int. Cl.: H01L 31/0392

(54) **Roll-to-roll apparatus and method for manufacturing a product comprising a target substrate provided with at least one foil shaped component**

(71) Applicant: Nederlandse Organisatie voor Toegepast -Natuurwetenschappelijk Onderzoek TNO, 2628 VK Delft (NL)
(72) Inventor: van den Brand, Jeroen, 2628 VK Delft (NL); Aritunov, Gari, 2628 VK Delft (NL); Smits, Edsger Constant Pieter, 2628 VK Delft (NL); Dietzel, Andreas Heinrich, 2628 VK Delft (NL)
(74) Representative: Jansen, Cornelis Marinus

(57) **Abstract**

A roll-to-roll apparatus is disclosed for manufacturing a product comprising a target substrate (TS) provided with at least one foil shaped component (CP). The apparatus comprises
- a transfer body (10) with a cylindrical transfer surface (14) provided with a pattern of at least one binding area (16) having a relatively high affinity for an alignment liquid (LQ) in comparison to a surrounding area (18),
- a liquid application facility (20) for applying the alignment liquid (LQ) onto said cylindrical transfer surface (14),
- a substrate supply facility (32, 34) for supplying the substrate (TS),
- a rotation facility (40) coupled to the transfer body (10) for rotating the cylindrical transfer surface (14) around a rotation axis (12) of the cylindrical transfer surface,
- a component application facility (50) for applying a respective foil shaped component (CP) onto the alignment liquid (LQ) in the at least one binding area (16),
and
- a control facility (70) for controlling the apparatus so that the applied respective foil shaped component (CP) is displaced to an assembly position where it faces the substrate (TS), while it is aligned to the binding area through capillary forces exerted by the alignment liquid during said displacement, and causing the apparatus to bring the aligned respective foil shaped component into contact with the target substrate in said assembly position in order to transfer the foil shaped component to the target substrate.

## Description

### BACKGROUND OF THE INVENTION

### Field of the invention

The present invention relates to a roll-to-roll apparatus for manufacturing a product comprising a target substrate provided with at least one foil shaped component.

The present invention further relates to a method for manufacturing a product comprising a target substrate provided with at least one foil shaped component.

### Related Art

Roll-to-roll manufacturing of flexible products is a promising development. Therewith a flexible web may be provided with electronic, optical and electro-optical functions for example. In the roll-to-roll manufacturing process the web may be guided along several stations, such as deposition stations for depositing (structured) a layer, and process stations, for processing a layer, for example by curing or drying a layer. A roll-to-roll manufacturing system may further comprise an assembly station for assembling additional foil shaped components with the web. The additional foil shaped components may be systems-in-foil which may have a size in the range of a few square mm to a few square cm. Assembly of such additional foil shaped components with a moving web is complicated.

### SUMMARY OF THE INVENTION

It is an object of the invention to provide an improved roll-to-roll apparatus for manufacturing a product comprising a target substrate provided with at least one component.

It is a further object of the invention to provide an improved roll-to-roll method for manufacturing a product comprising a target substrate provided with at least one component.

In accordance with a first aspect of the invention a roll-to-roll apparatus is provided as claimed in claim 1.

In accordance with a second aspect of the invention a roll-to-roll method is provided as claimed in claim 11.

In the apparatus and method according to the present invention, the foil shaped component is assembled with the target substrate in two steps. In a first step the foil shaped component is applied to the cylindrical transfer surface of a transfer body, and in a subsequent step the foil shaped component is transferred from the cylindrical transfer surface to the target substrate. It has been found by the inventors that the capillary forces exerted by the alignment liquid dominate other forces occurring on the foil shaped component. Accordingly, while carried on the cylindrical transfer surface the foil shaped component is allowed to align to the binding area through the capillary forces exerted by the alignment liquid. In the aligned state the foil shaped component is adhered to the target substrate. In the context of the present invention, a surface is considered to have a relatively high affinity for a liquid if the contact angle of the liquid with the surface is less than 20°, preferably less than 15°, for example around 10°, and to have a relatively low affinity if the contact angle of the liquid with the surface is greater than100°, preferably greater than 110°, e.g. about 120°. For a reliable operation also at high manufacturing speeds it is desirable that the contact angle of the liquid with the binding areas is at least 90° less than the contact angle of the liquid with the surrounding area.

Typically the component that is applied to the substrate has an active side that is brought into contact with the substrate and a non-active side with which the component is, temporarily, applied to a binding area of the cylindrical transfer surface. As the only the non-active side of the component needs to come into contact with the alignment liquid the choice of the alignment liquid is not very critical. I.e. also water is suitable as the alignment liquid, even if the foil shaped components to be applied on the substrate are electronic components. The non-active side of the foil shaped components need to have a sufficiently high affinity for the alignment liquid. This requirement is however easily met. Commonly used, untreated foils, such PEN or PET are suitable for this purpose for example.

Depending on the alignment liquid used, the required contact angles can be achieved in various ways. In case the contact liquid is water, a relatively low contact angle of about 10° may be obtained with a silicon or glass surface for example. A relatively high contact angle in the range of 110-120° can be obtained by a plasma treatment or by deposition of an additional silane or fluoro SAM (self-assemble monolayer).

### BRIEF DESCRIPTION OF THE DRAWINGS

These and other aspects are described in more detail with reference to the drawing. Therein:
FIG. 1 schematically shows in a perspective view a roll-to-roll apparatus according to the first aspect of the present invention,
FIG. 1A provides a planarized view of a part of the apparatus of FIG. 1,
FIG. 1B shows a cross-section according to BB in FIG. 1A,
FIG. 2A-2E shows a first embodiment of the roll-to-roll apparatus according to the invention in subsequent operational states, in FIG. 2B to 2E some details visible in FIG. 2A are left out for clarity; in these Figures,

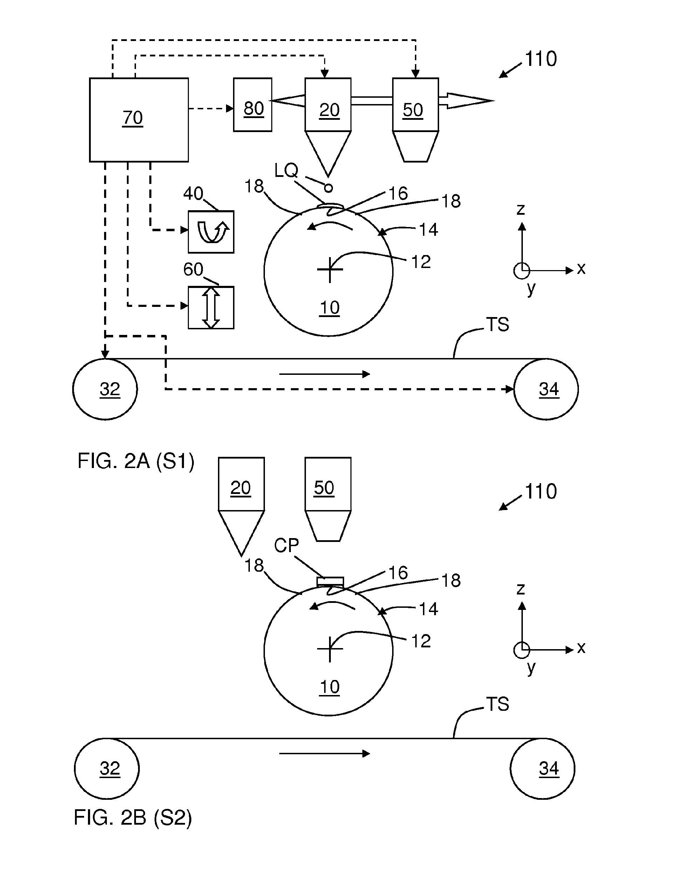

FIG. 2A shows the roll-to-roll apparatus according to the first embodiment in a first operational state,
FIG. 2B shows the roll-to-roll apparatus according to the first embodiment in a second operational state,

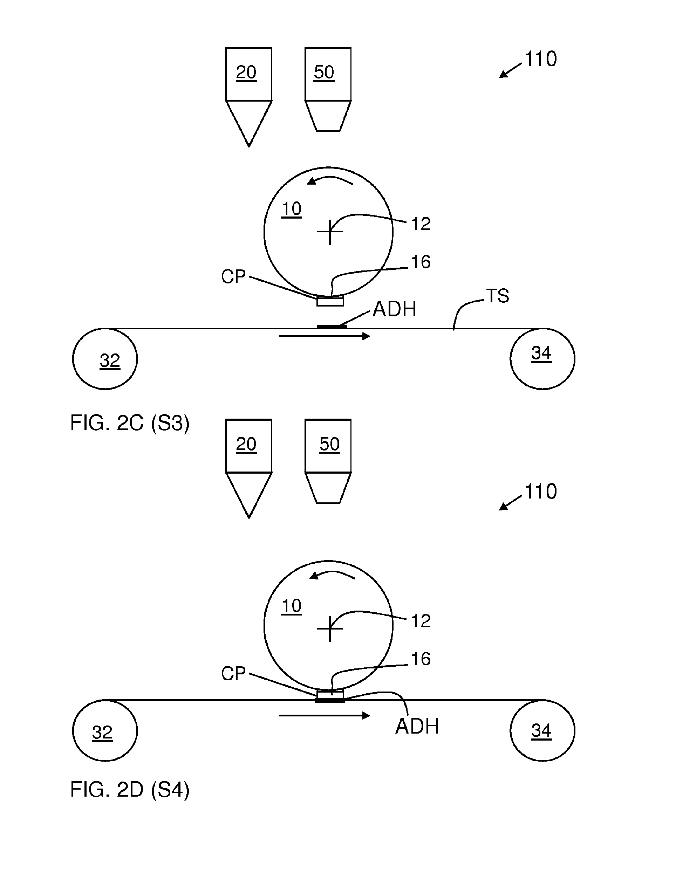

FIG. 2C shows the roll-to-roll apparatus according to the first embodiment in a third operational state,
FIG. 2D shows the roll-to-roll apparatus according to the first embodiment in a fourth operational state,

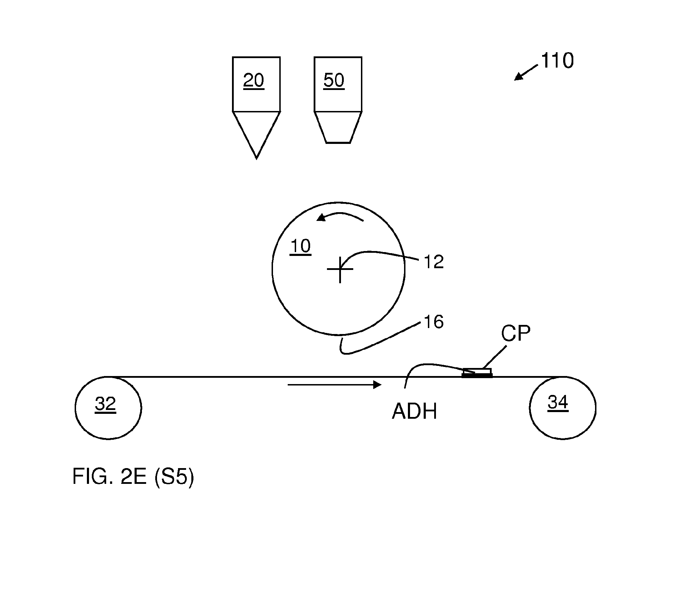

FIG. 2E shows the roll-to-roll apparatus according to the first embodiment in a fifth operational state,

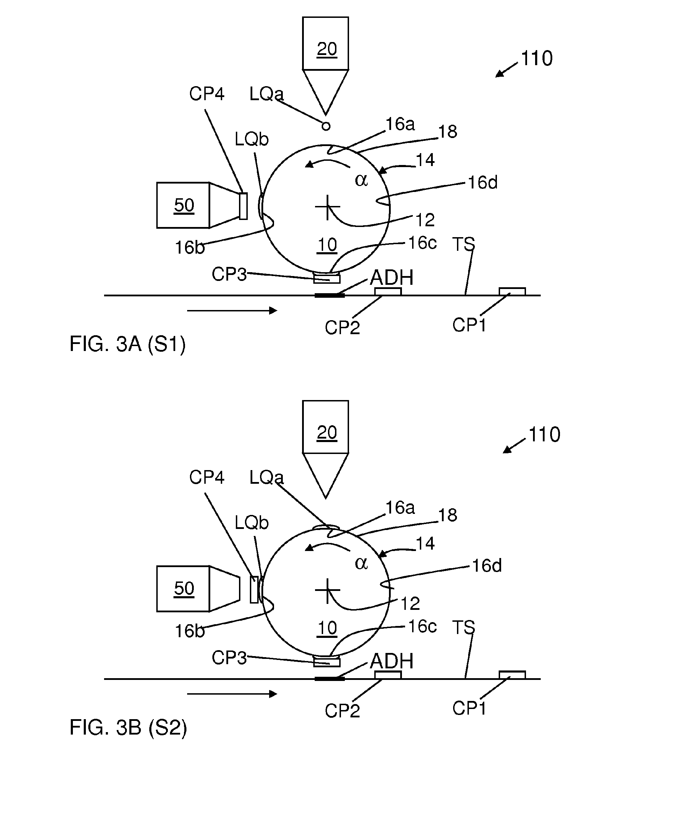

FIG. 3A-3C shows a second embodiment of the roll-to-roll apparatus according to the invention in subsequent operational states; in these Figures,
FIG. 3A shows the roll-to-roll apparatus according to the second embodiment in a first operational state,
FIG. 3B shows the roll-to-roll apparatus according to the second embodiment in a second operational state,

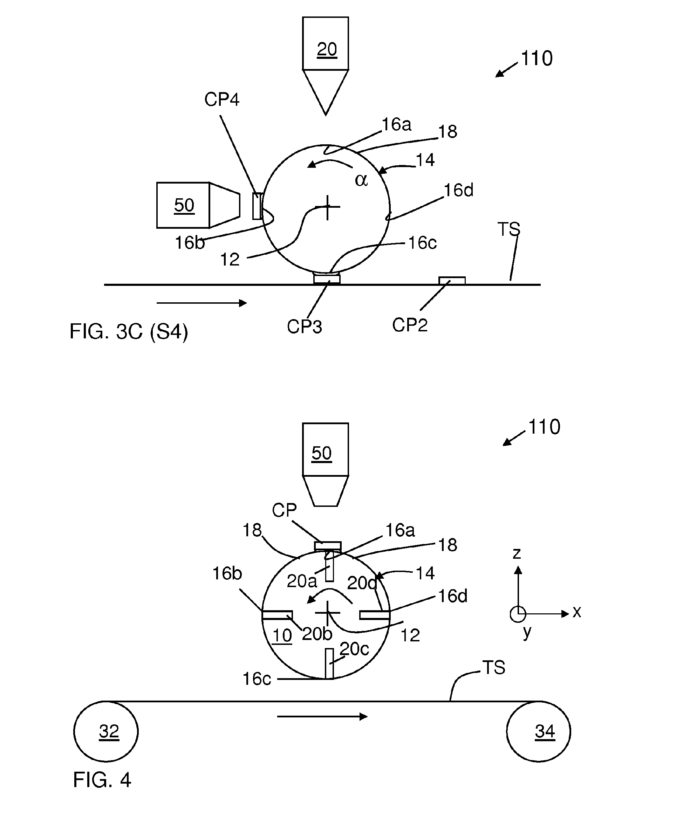

FIG. 3C shows the roll-to-roll apparatus according to the second embodiment in a third operational state,
FIG. 4 shows a third embodiment of a roll-to-roll apparatus according to the invention,

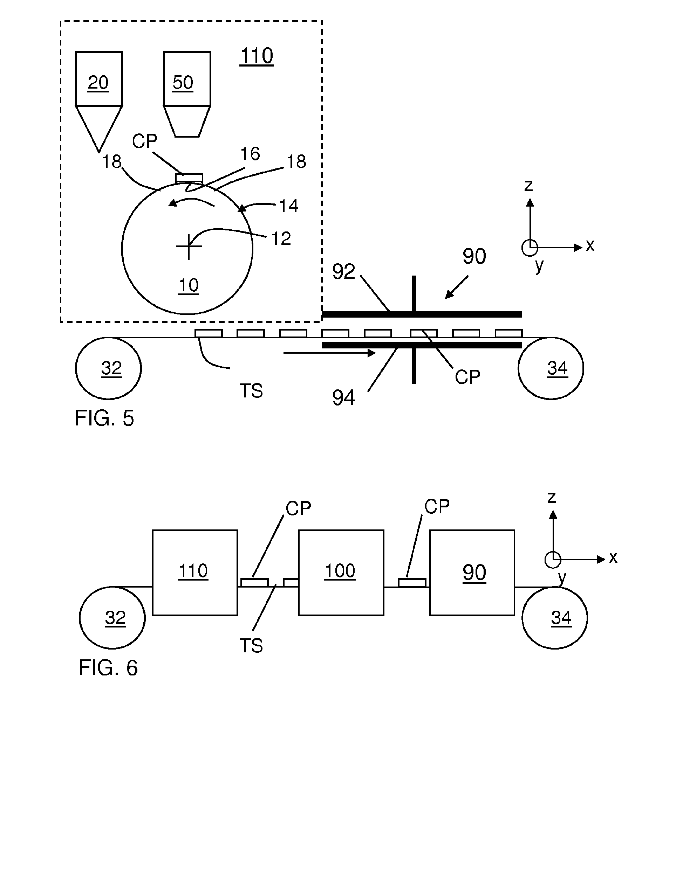

FIG. 5 shows a fourth embodiment of a roll-to-roll apparatus according to the invention,
FIG. 6 schematically shows a fifth embodiment of a roll-to-roll apparatus according to the invention,

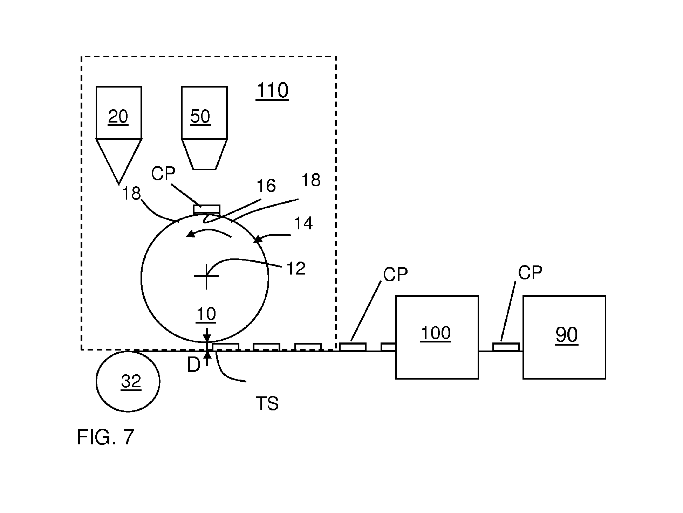

FIG. 7 schematically shows a sixth embodiment of a roll-to-roll apparatus according to the invention.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures.

It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below.

The device may be otherwise oriented (rotated 90 degrees or at other orientations) and the spatially relative descriptors used herein interpreted accordingly.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All publications, patent applications, patents, and other references mentioned herein are incorporated by reference in their entirety. In case of conflict, the present specification, including definitions, will control. In addition, the materials, methods, and examples are illustrative only and not intended to be limiting.

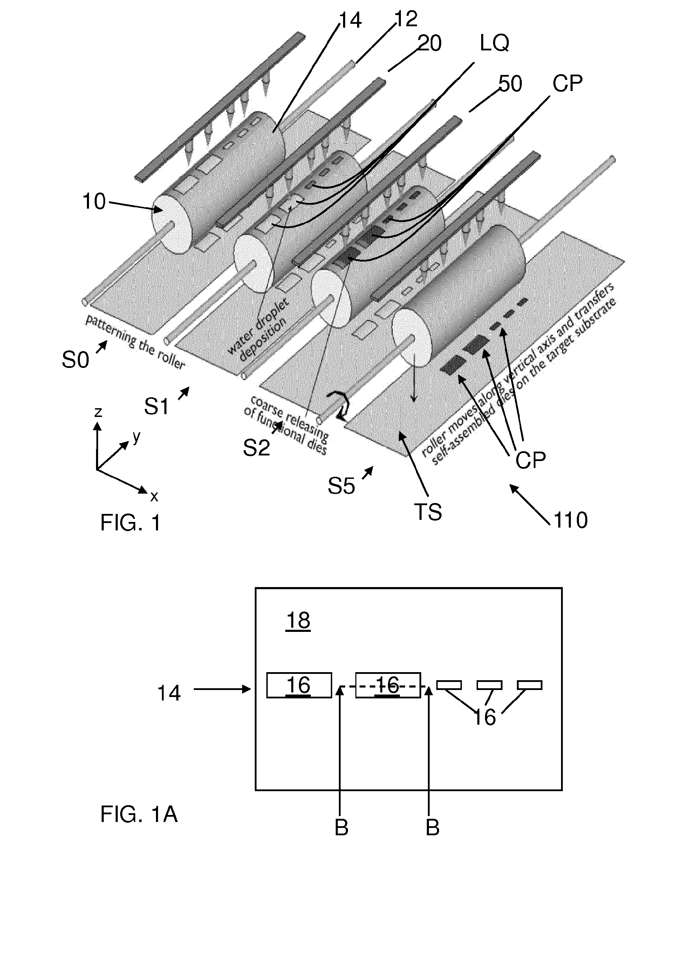

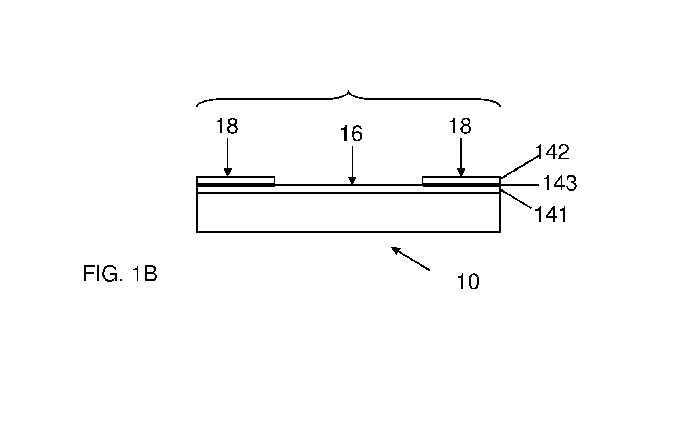

FIG. 1 schematically shows in a perspective view a roll-to-roll apparatus according to the first aspect of the present invention for manufacturing a product comprising a target substrate TS provided with at least one foil shaped component CP. FIG. 1 shows the apparatus in four successive operational states S1- S4. Reference is further made to FIG. 2A to 2E which shows different states of the apparatus in a side view

The apparatus of FIG. 1 comprises a transfer body 10 having a cylindrical transfer surface 14 that is coaxial with said rotation axis 12. The apparatus further comprises a liquid application facility, in this case a deposition facility 20 for depositing an alignment liquid LQ onto the cylindrical transfer surface 14. FIG. 1A provides a planarized view of the cylindrical transfer surface 14. It is seen therein that the cylindrical transfer surface 14 is provided with a pattern of at least one binding area 16 that is surrounded by a surrounding area 18. The binding area 16 has a relatively high affinity for the alignment liquid in comparison to the surrounding area 18 that has a relatively low affinity for the alignment liquid. It is not necessary that the liquid LQ is deposited exactly conformal to the area of the binding area. Even if the liquid initially does not fully cover the binding area, it tends to spread out over the area immediately after its deposition. Alignment liquid that is deposited in the surrounding areas tends to withdraw to the binding areas or to drop from the surface.

As can best be seen in FIG. 2A-2E, the apparatus further has a substrate supply facility 32, 34 for supplying the substrate TS. In this case the substrate supply facility comprises a supply roller 32 and a storage roller 34.

The apparatus is further provided with a component application facility 50 for applying foil shaped component CP onto the alignment liquid LQ in the at least one binding area 16. In rare cases wherein the alignment liquid LQ is not fully spread over the area of the binding area(s), the weight of the component causes spreading of the alignment liquid.

As can be seen in FIG. 2A, the apparatus further has a moving facility 60 for moving the transfer body 10 with the binding areas 16 carrying the respective foil shaped component CP and the target substrate TS towards each other so as to transfer the foil shaped component to the target substrate. Typically the moving facility 60 will move the transfer body 10 towards target substrate TS. The substrate supply facility 32, 34 is synchronized with the transfer body 10, so that the tangential speed of the cylindrical transfer surface 14 corresponds to the speed with which the substrate TS is supplied.

Synchronization may take place according to a rigid clock mechanism that mechanically couples the substrate supply facility 32, 34 and a rotation facility 40 (See FIG. 2A). Alternatively one of the substrate supply facility 32, 34 or the rotation facility 40 may be controlled by a servo mechanism to synchronize its movement to the other one. Such a servo-mechanism may for example use optical detection means, e.g. detecting marker patterns on the substrate or on the cylindrical transfer surface.

As further shown in FIG. 2A, the apparatus has a control facility 70 for controlling the facilities 10, 20, 32, 34, 50, 60 described above. I.e. during operation of the apparatus the control facility causes the alignment liquid application facility 20 to apply the alignment liquid LQ onto the cylindrical transfer surface 14 of the transfer body 10. It causes the foil shaped component application facility 50 to apply a respective foil shaped component CP onto the alignment liquid LQ in a binding area 16 of the cylindrical transfer surface 14. It causes the rotation facility 40 to rotate the transfer body 10 around its axis 12 so that the foil shaped component CP is displaced to an assembly position where it faces the substrate TS. During this rotation the foil shaped component CP is aligned to the binding area through capillary forces exerted by the alignment liquid LQ. The roll-to-roll apparatus is being arranged for bringing the aligned foil shaped component into contact with the target substrate in said assembly position in order to transfer the foil shaped component to the target substrate.

In the embodiment shown, the apparatus further has a displacement facility 80 for alternatingly positioning the alignment liquid application facility 20 and the component application facility 50 in a position above the cylindrical transfer surface 14.

In the operational state shown in FIG. 2A, the displacement facility positions the liquid application facility 20 above the cylindrical transfer surface 14, and the control facility causes the deposition facility 20 to deposit the alignment liquid LQ onto the cylindrical transfer surface 14 of the transfer body 10). Subsequently, as shown in FIG. 2B, the component application facility 50 is positioned above the cylindrical transfer surface 14, and the control facility 70 causes the component application facility 50 to apply a respective foil shaped component CP onto the alignment liquid LQ in the at least one binding area 16. After the respective foil shaped component CP is applied the control facility 70 causes the rotation facility 40 to rotate the transfer body 10 around its axis 12. Therewith the foil shaped component CP is displaced to an assembly position, wherein it faces the target substrate TS, as shown in FIG. 2C. The control facility subsequently causes the moving facility 60 to bring the binding area 16 carrying the respective foil shaped component CP into contact with the target substrate TS. Capillary forces exerted by the alignment liquid (LQ) align the foil shaped component CP while it is displaced to said assembly position. The roll-to-roll apparatus is arranged to bring the aligned respective foil shaped component into contact with the target substrate in said assembly position in order to transfer the foil shaped component to the target substrate. In this embodiment the roll-to-roll apparatus is arranged for this purpose in that it is provided with a moving facility 60 for moving the transfer body with the binding area 16 carrying the foil shaped component CP and the target substrate (TS) towards each other so as to transfer the foil shaped component to the target substrate. The apparatus is controlled to maintain the transfer body 10 in a fixed rotational position and to maintain the substrate in a fixed position transverse to the movement during said movement until the foil shaped component CP is transferred from the transfer body 10 to the target substrate TS.

Referring again to FIG. 1, 1A, 1B and 2A to 2E, now an embodiment of a method according to the second aspect of the invention is described.

FIG. 1 shows the result of a preparation step S0 wherein a transfer body 10 is provided that has a rotation axis 12 and a cylindrical transfer surface 14 coaxial with the rotation axis. The cylindrical transfer surface 14 has a pattern of at least one binding area 16 with a relatively high affinity for an alignment liquid and a surrounding area 18 by having a relatively low affinity for the alignment liquid that surrounds the binding area 16.

A preferred alignment liquid is water, but alternatively other alignment liquids may be used, such as oil, alcohol. Also a liquid metal, e.g. mercury, or liquid tin may serve as the alignment liquid.

The preparation of the cylindrical transfer surface 14 depends on the selection of the alignment liquid used. For example, if the alignment liquid is water, the at least one binding area should have a hydrophilic character, and the surrounding area should have a hydrophobic character. If for example the alignment liquid is an oil, then the at least one binding area should have a lipophilic character, and the surrounding area should have a lipophobic character.

Various options are possible to obtain the desired patterning in higher and lower affinity for the alignment liquid.

According to one option an inner layer is provided of a first material having the relatively high affinity and a patterned coating of a second material is applied thereon having the relatively low affinity. For example, the first material may be selected from one of silicon and glass, and the second material may be selected from one of a metal and Teflon. The patterned coating of the second material is for example a patterned metal sheet that is wrapped around the inner layer of the first material.

It is alternatively possible to provide an inner layer of a material having a relatively low affinity, for example selected from one of a metal and Teflon and a coating in a pattern complementary to the pattern used for said one option.

In a particular embodiment shown, in more detail in FIG. 1B as a cross-section BB of FIG. 1A, the transfer body 10 has a first surface layer 141 of silicon oxide, that is coated with a patterned surface layer 142 of gold (Au). The gold layer 142 is adhered by a titanium layer 143 to the underlying silicon oxide layer. The gold layer 142 and the titanium layer 143, conformal therewith exposes parts of the underlying silicon oxide layer. These exposed parts form the binding areas 16 having the high affinity for the alignment liquid, whereas the surrounding areas covered by the gold layer 142 have a low affinity for the alignment liquid.

The patterned surface 14 shown in FIG. 1B was obtained by sequentially sputtering a 5 nanometer Ti layer and a 100 nm Au layer over a 1 µm-thick layer of SiO2 thermally grown on the Si wafer. The so obtained stack of layers was spin coated with a positive photo resist that was subsequently patterned and developed to define the binding sites 16. Subsequently Au and Ti were removed from the binding sites by wet etching and after the remaining photo resist was striped the substrate was cleaned by an O₂ plasma. Then a fluorinated alkanethiol self-assembled monolayer was selectively deposited on the Au surface.

Subsequently in step S1, see also FIG. 2A, an amount of the alignment liquid LQ is deposited onto the cylindrical transfer surface 14. In this case water, serving as the alignment liquid, forms a contact angle of (8° ± 2°) on the exposed SiO2 sites 16 and a contact angle of (120° ± 3°) on the surrounding areas 18.

Preferably the alignment liquid LQ is specifically deposited onto the binding areas 16. However, due to the fact that the contact angle of the alignment liquid is significantly higher for the binding areas 16 than for the surrounding areas 18, this it is not strictly necessary as the alignment liquid tends to be rejected from the surrounding areas and withdraw to the binding areas or to drop from the roller. Nevertheless, it is favorable to specifically deposit the alignment liquid onto the binding areas 16, so that the amount of alignment liquid received by the binding areas 16 can be accurately controlled.

In a next step S2, also shown in FIG. 2B a respective foil shaped component CP was applied onto the alignment liquid LQ in the at least one binding area 16. Once the foil shaped component CP is applied, capillary forces exerted by the alignment liquid cause a self-alignment of the foil shaped component CP with the binding area 16.

To estimate the optimum thickness of the alignment liquid, the amount of alignment liquid deposited into the binding areas 16 was systematically varied from 50 to 200 µm thickness with steps of 25 µm. Each measurement was repeated 5 times. It was found that when excessive water was used, tilting of the foil shaped components CP on the alignment liquid was observed. Conversely, when a too small amount of the alignment liquid was used, due to even very small initial tilting angles of the foil dies the capillary forces could not overcome the friction forces resulting from direct contact of the foils with the unlubricated substrate, and accurate alignment could not be obtained. In particular 80 to 125 µm-thick layers of the alignment liquid gave the best results.

Simultaneously a substrate TS is supplied (Step SX), and in step S3 the cylindrical transfer surface 14 is rotated around the rotation axis 12 until the at least one binding area carrying the respective foil shaped component CP faces the substrate TS as shown in FIG. 2C.

As can be seen in FIG. 2D, in step S4 the transfer body 10 with the binding area 16 carrying the respective foil shaped component CP is moved towards the target substrate TS so as to bring the foil shaped component CP into contact with the target substrate in order to transfer the foil shaped component from the transfer body 10 to the target substrate TS. During this movement the transfer body 10 is maintained in a fixed rotational position and the substrate is maintained in a fixed position transverse to the movement until the respective foil shaped component CP is transferred from the transfer body to the target substrate. The foil shaped component CP is considered transferred if the transfer body 10 and the target substrate TS are moved apart from each other again, and the foil shaped component CP remains at the substrate. Then the rotation of the transfer body 10 and the transport of the target substrate TS can be resumed. In an embodiment the transfer body 10 is maintained for some time with pressure against the target substrate TS when the foil shaped component CP is into contact with the target substrate TS, in order to bond the component CP with the target substrate.

The foil shaped component CP is then adhered to the target substrate TS, for example using an adhesive ADH applied to the target substrate TS. Alternatively the adhesive may be applied to the foil shaped component CP at a side facing the target substrate. In another embodiment a two-component adhesive may be used with a first adhesive component applied to the foil shaped component CP and a second adhesive component applied to the target substrate TS, so that curing of the adhesive occurs starts at the moment that the foil shaped component CP comes into contact with the target substrate TS as shown in FIG. 2D.

Various options are possible for the adhesive and the way it is applied. Use of an anisotropically conductive adhesive is preferred as in that case it is not necessary to apply the adhesive in a patterned way. In that case a simple coating method, such as spraying, suffices to apply the adhesive. Alternatively an isotropically conductive adhesive is applied that is applied in a patterned fashion, to avoid electrical shortcuts. In that case the adhesive may be applied by a printing method, such as screen printing.

The embodiment of the apparatus wherein the transfer body 10 is used for press bonding the component CP will be relatively slow, because the transfer body cannot rotate to a next angular position until bonding is completed, which may be a matter of minutes. An alternative embodiment that overcomes this disadvantage is described with reference to FIG. 5.

In a subsequent step (S5) shown in FIG. 2E, the transfer body is released from the target substrate TS, leaving the foil shaped component CP adhered to target substrate TS. The target substrate TS can then be transported to a next position and the transfer body is rotated towards the position state S1 shown in FIG. 2A, in order to carry out the next cycle of the manufacturing process.

FIG. 3A and 3B show another embodiment of the apparatus according to the first aspect of the invention. By way of example the transfer body 10 has four binding sites 16a, 16b, 16c, 16d that are arranged at the cylindrical transfer surface 14 at orientations α with respect to the axis 12 of the transfer body 10 that mutually differing by an angular step Δα of 90°. Alternatively an other angular step Δα, e.g. 45 or 30°. In the example shown the deposition facility 20 and the component application facility 50 also are arranged at orientations α differing said angular step Δα or a multitude thereof from each other. FIG. 3A shows a first operational state, wherein the deposition facility 20 has just released a drop of alignment liquid LQa to be deposited on a binding area 16a at a side of the transfer body 10 facing upwards at that state. A binding area 16b at second side of the transfer body 10 facing towards to the component application facility 50 is already provided with a drop of alignment liquid LQb in a previous state.

In a subsequent operational state shown in FIG. 3B, the component application facility 50 has applied the foil shaped component CP4 to the binding area 16b and the drop of alignment liquid LQa is deposited on a binding area 16a.

FIG. 3C shows a further operational state, wherein the transfer body 10 has moved downwards, i.e. towards the target substrate TS. Therewith a binding area 16c carrying a foil shaped component CP3 is brought into contact with the target substrate TS so that the foil shaped component CP3 is transferred from the binding area 16c to the target substrate TS. After this transfer is completed and the transfer body is moved upwards, back to its original position, the transfer body 10 rotates by the angular step Δα° and the apparatus returns to the operational state of FIG. 3A to start a new cycle. The time between subsequent cycles should be long enough to allow the foil shaped components, here CP4, to align to the binding area through capillary forces exerted by the alignment liquid LQ in time-interval between its application onto the alignment liquid LQ and the moment it is brought into contact with the target substrate TS.

Also in this embodiment the transfer body 10 is maintained for some time with pressure against the target substrate TS when the foil shaped component CP is into contact with the target substrate TS, in order to bond the component CP with the target substrate, which may be relatively slow. An alternative embodiment that overcomes this disadvantage is described with reference to FIG. 5.

In the embodiments described above, the liquid application facility 20 is at least at the moment of ejecting the liquid arranged above the cylindrical transfer surface 14. In this way gravitation facilitates application of the alignment liquid LQ onto the cylindrical transfer surface 14. Nevertheless, it is alternatively possible that the liquid application facility 20 is arranged at an other position with respect to the cylindrical transfer surface, provided that the liquid is ejected with pressure.

FIG. 4 shows an again further embodiment wherein the liquid application facility is integrated within the transfer body 10. The liquid application facility is formed by microtubes 20a, ..., 20d, that lead from inside the transfer body 10 to a respective binding area 16a,...,16d at the cylindrical transfer surface 14.

FIG. 5 shows a fourth embodiment of a roll-to-roll apparatus according to the invention. In the embodiment of FIG. 5, the roll-to-roll apparatus further comprises a press-bonding facility 90 for simultaneously press-bonding a plurality of said foil shaped components CP applied in a transport direction x of the target substrate TS. By way of example, the press-bonding facility 90 shown in FIG. 5 is capable of simultaneously press-bonding five of said foil shaped components CP. During operation the movement of the press-bonding facility 90 is synchronized with the movement of the other facilities 10, 32, 34 of the roll to roll apparatus. In particular, during time intervals that the substrate is maintained in a fixed position, plates 92, 94 of the press-bonding facility 90 exert a clamping force in order to bond foil shaped components CP to the target substrate TS. Once a foil shaped component CP leaves the press-bonding facility 90 in the x-direction it has been clamped to the target substrate N times. In this case N= 5, but any value can be chosen, in order to ensure that the components CP are soundly bonded to the target substrate TS without holding up the assembly process. In this case the transfer body 10 only needs to transfer the components CP to the target substrate TS. To that end the transfer body 10 only needs to bring the components into contact with the target substrate TS, but it is not necessary that it exerts a large or longduring pressure therewith.

Any of the previous described embodiments can be provided with a press-bonding facility 90 as described with reference to FIG. 5.

FIG. 6 schematically shows a fifth embodiment of a roll-to-roll apparatus according to the invention. In this fifth embodiment, the roll-to-roll apparatus comprises transfer arrangement 110. This transfer arrangement can be composed according to the embodiments as described with reference to FIG. 1 to 4. Again it is sufficient that the transfer arrangement transfers the components CP to the target substrate TS. In the embodiment of FIG. 5, a press-bonding facility 90 is provided. In this case the press-bonding facility 90 operates batch-wise. At each cycle the press-bonding facility 90 accepts a length of the target substrate TS provided with a plurality of respective foil shaped components CP arranged in the transport direction x. The embodiment of FIG. 6 further comprises a buffer facility 100 for temporary holding the substrate with a next plurality of respective foil shaped components CP until it can be accepted by the press-bonding facility 90. In this way the press-bonding facility 90 can apply its clamping force continuously, so that in a same time interval the effective clamping time is longer.

FIG. 7 shows a sixth embodiment of a roll-to-roll apparatus according to the invention. Therein the cylindrical transfer surface 14 of the transfer body 10 is maintained at a predetermined distance D from the target substrate TS. This distance corresponds to a thickness of the respective foil shaped components (CP). The roll-to-roll apparatus further comprises a press-bonding facility 90. The press-bonding facility 90 is arranged for simultaneously press-bonding a plurality of foil shaped components CP applied in a transport direction x of the target substrate TS. In this embodiment the transfer body 10 is continuously rotated at a substantially constant velocity. Due to the fact that the cylindrical transfer surface 14 of the transfer body 10 is maintained at a predetermined distance D from the target substrate TS, wherein the distance substantially corresponds to the thickness of the foil shaped components, it is rendered possible that the transfer body 10 is continuously rotated provided that the target substrate is moved in the x-direction at a speed corresponding to the tangential speed of foil shaped component CP. Under these circumstances the forces exerted by the alignment liquid are sufficiently strong to maintain the foil shaped component CP in its aligned state, while it is transferred to the target substrate TS. As in the embodiment of FIG. 6, the roll-to-roll apparatus further comprises a buffer facility 100. The buffer facility is capable of temporary holding the substrate with a next plurality of respective foil shaped components CP until it can be accepted by the press-bonding facility 90. Therewith the press-bonding facility 90 can exert its clamping force continuously, until a plurality of respective foil shaped components therein is fully adhered to the target substrate. This embodiment further has the advantage that the transfer process performed by transfer arrangement 110 can proceed in a continuous manner. It is a further advantage that a moving facility for moving the transfer body 10 and the target substrate TS towards each other is not necessary. In case foil shaped components CP having another thickness are to be transferred it is necessary however to adjusting the distance between the cylindrical transfer surface and the target surface accordingly.

In this connection the embodiments of FIG. 1-6 have the advantage that it is suitable for transferring components of different thicknesses, without adjusting the apparatus, provided that they need not be arranged at the same x position of the target substrate. In summary, the present invention discloses a roll-to-roll apparatus for manufacturing a product comprising a target substrate with at least one foil shaped component. The apparatus comprises
- a transfer body with a cylindrical transfer surface provided with a pattern of at least one binding area having a relatively high affinity for an alignment liquid in comparison to a surrounding area,
- a liquid application facility for applying the alignment liquid onto the cylindrical transfer surface,
- a substrate supply facility for supplying the substrate,
- a rotation facility coupled to the transfer body for rotating the cylindrical transfer surface around a rotation axis of the cylindrical transfer surface,
- a component application facility for applying a respective foil shaped component onto the alignment liquid in the at least one binding area,
- a control facility for controlling the apparatus so that the applied respective foil shaped component (CP) is displaced to an assembly position where it faces the substrate (TS), while it is aligned to the binding area through capillary forces exerted by the alignment liquid during said displacement, and causing the apparatus to bring the aligned respective foil shaped component into contact with the target substrate in said assembly position in order to transfer the foil shaped component to the target substrate.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A roll-to-roll apparatus for manufacturing a product comprising a target substrate (TS) provided with at least one foil shaped component (CP), the apparatus comprising:
- a transfer body (10) having a rotation axis and a cylindrical transfer surface (14) being coaxial with said rotation axis (12), the cylindrical transfer surface (14) being provided with a pattern of at least one binding area (16) having a first affinity for an alignment liquid (LQ), the at least one binding area being surrounded by a surrounding area (18) having a second, lower affinity for the liquid,
- a liquid application facility (20) for applying the alignment liquid (LQ) onto said cylindrical transfer surface (14),
- a substrate supply facility (32, 34) for supplying the substrate (TS),
- a rotation facility (40) coupled to the transfer body (10) for rotating the cylindrical transfer surface (14) around the rotation axis (12),
- a component application facility (50) for applying a respective foil shaped component (CP) onto the alignment liquid (LQ) in the at least one binding area (16), and
- a control facility (70) for controlling the apparatus so that the applied respective foil shaped component (CP) is displaced to an assembly position where it faces the substrate (TS), while it is aligned to the binding area through capillary forces exerted by the alignment liquid during said displacement, and causing the apparatus to bring the aligned respective foil shaped component into contact with the target substrate in said assembly position in order to transfer the foil shaped component to the target substrate.

2. The roll-to-roll apparatus according to claim 1, further comprising a moving facility (60) for moving the transfer body with the binding area (16) carrying the respective foil shaped component (CP) and the target substrate (TS) towards each other so as to transfer the foil shaped component to the target substrate, when the respective foil shaped component is in its assembly position, the transfer body (10) being maintained in a fixed rotational position and the substrate being maintained in a fixed position transverse to the movement during said movement and until the respective foil shaped component (CP) is transferred from the transfer body to the target substrate.

3. The roll-to-roll apparatus according to claim 2, further comprising a press-bonding facility (90), for simultaneously press-bonding a plurality of said respective foil shaped components (CP) applied in a transport direction (x) of the target substrate (TS).

4. The roll-to-roll apparatus according to claim 3, further comprising a buffer facility (100) for temporary holding the substrate with a next plurality of respective foil shaped components (CP) until it can be accepted by the press-bonding facility (90).

5. The roll-to-roll apparatus according to claim 1, wherein the cylindrical transfer surface (14) of the transfer body (10) is maintained at a predetermined distance from the target substrate (TS) corresponding to a thickness of the respective foil shaped component (CP), further comprising a press-bonding facility (90), for simultaneously press-bonding a plurality of said respective foil shaped components (CP) applied in a transport direction (x) of the target substrate (TS), wherein the transfer body (10) is rotated at a substantially constant velocity, and wherein the roll-to-roll apparatus further comprises a buffer facility (100) for temporary holding the substrate with a next plurality of respective foil shaped component (CP) until it can be accepted by the press-bonding facility (90).

6. The roll-to-roll apparatus according to claim 1, further comprising a displacement facility (80) for alternatingly positioning the alignment liquid application facility (20) and the component application facility (50) in a position above the cylindrical transfer surface (14).

7. The roll-to-roll apparatus according to claim 1, wherein the alignment liquid application facility (20) and the component application facility (50) have mutually different, predetermined positions.

8. The roll-to-roll apparatus according to claim 1, wherein the liquid application facility is formed by tubes (20a, ..., 20d), that lead from within the transfer body (10) to a respective binding area (16a,...,16d) at the cylindrical transfer surface (14).

9. The roll-to-roll apparatus according to one of the previous claims, wherein the transfer body comprises an inner layer of a first material having the first affinity and a patterned coating of a second material having the second affinity.

10. The roll-to-roll apparatus according to claim 1, wherein the transfer body comprises an inner layer of a first material having the first affinity and a patterned coating of a second material having the second affinity.

11. A roll-to-roll method for manufacturing a product comprising a target substrate (TS) provided with at least one foil shaped component (CP), the method comprising the steps:
- applying (S1) an amount of an alignment liquid (LQ) onto a cylindrical transfer surface (14) of a transfer body (10) having a rotation axis (12), the cylindrical transfer surface (14) being coaxial with the rotation axis and having a pattern of at least one binding area (16) having a relatively high affinity for an alignment liquid and being surrounded by a surrounding area (18) having a relatively low affinity for the alignment liquid,
- applying (S2) a respective foil shaped component (CP) onto the alignment liquid (LQ) in the at least one binding area (16),
- supplying (SX) a substrate (TS),
- rotating (S3) the cylindrical transfer surface (14) around the rotation axis (12), the applied respective foil shaped component (CP) therewith being displaced to an assembly position where it faces the substrate (TS),
while being aligned to the binding area through capillary forces exerted by the alignment liquid during said displacement to said assembly position and bringing the foil shaped component into contact with the target substrate and bringing the aligned respective foil shaped component into contact with the target substrate in said assembly position in order to transfer the foil shaped component to the target substrate.

12. The roll-to-roll method according to claim 11, comprising
- in said assembly position moving (S4) the transfer body with the binding area (16) carrying the respective foil shaped component (CP) and the target substrate (TS) towards each other so as to bring the foil shaped component into contact with the target substrate,
- moving (S5) the transfer body (10) away from the target substrate (TS) after the respective foil shaped component is brought into contact with the target substrate,
- maintaining the transfer body in a fixed rotational position and the substrate in a fixed position transverse to the movement, until the foil shaped component is transferred to the target substrate.

13. The roll-to-roll method according to claim 12, further comprising the step of simultaneously press-bonding a plurality of said respective foil shaped components (CP) applied in a transport direction (x) of the target substrate (TS).

14. The roll-to-roll method according to claim 13, further comprising temporary holding the substrate with a next plurality of respective foil shaped components (CP) until it can be accepted by the press-bonding facility (90).

15. The roll-to-roll method according to claim 11, comprising
- maintaining the cylindrical transfer surface (14) of the transfer body (10) at a predetermined distance from the target substrate (TS) corresponding to a thickness of the respective foil shaped component (CP),
- simultaneously press-bonding a plurality of said respective foil shaped
rotating components (CP) applied in a transport direction (x) of the target substrate (TS),
- rotating the transfer body at a substantially constant velocity, and
- temporary holding the substrate with a next plurality of respective foil shaped component (CP) until it can be press-bonded simultaneously.
